(19) Europäisches Patentamt
European Patent Office
Office européen des brevets

(11) **EP 4 197 964 A1**

(12) **DEMANDE DE BREVET EUROPEEN**

(43) Date de publication:
**21.06.2023 Bulletin 2023/25**

(51) Classification Internationale des Brevets (IPC):
**B81B 7/00** *(2006.01)* **B81B 3/00** *(2006.01)*

(21) Numéro de dépôt: **22214110.3**

(52) Classification Coopérative des Brevets (CPC):
**B81B 7/0019; B81B 3/0072;** B81B 2201/0242;
B81B 2203/0163; B81B 2203/056

(22) Date de dépôt: **16.12.2022**

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**KH MA MD TN**

(30) Priorité: **17.12.2021 FR 2113767**

(71) Demandeur: **Commissariat à l'énergie atomique
et aux énergies alternatives
75015 Paris (FR)**

(72) Inventeurs:
• **L'inventeur a renoncé au droit d'être mentionné
en tant que tel.**

(74) Mandataire: **Cabinet Camus Lebkiri
25 rue de Maubeuge
75009 Paris (FR)**

(54) **MICROSYSTÈME DESTINÉ À MESURER UN MOUVEMENT DE ROTATION ET DISPOSITIF DE MESURE ASSOCIÉ**

(57) Un aspect de l'invention concerne un microsystème (MS) comprenant : un substrat ; une partie principale (PP) reliée au substrat par l'intermédiaire d'un ancrage (AN) ; une partie mobile (PM), la partir mobile (PM) étant configurée pour tourner autour d'un axe de rotation O ; une première poutre (P1) reliant la partie mobile (PM) à la partie principale (PP), la direction principale de ladite première poutre (P1) étant selon un premier vecteur $\mathbf{e_{j1}}$ ayant pour origine la jonction $M_1$ de la partie mobile (PM) avec la première poutre (P1) et dans le sens de la partie principale (PP) ; une deuxième poutre (P2) reliant la partie mobile (PM) à la partie principale (PP), la direction principale de ladite deuxième poutre (P2) étant selon un deuxième vecteur $\mathbf{e_{j2}}$ ayant pour origine la jonction $M_2$ de la partie mobile (PM) avec la deuxième poutre (PP) et dans le sens de la partie principale (PP). De plus, le premier vecteur $\mathbf{e_{j1}}$ et le deuxième vecteur $\mathbf{e_{j2}}$ ont même direction et sont de sens opposé et la position des jonctions $M_1$ et $M_2$ est choisie de sorte que le produit vectoriel $\mathbf{O'M_1} \wedge \mathbf{e_{j1}}$ et le produit vectoriel $\mathbf{O'M_2} \wedge \mathbf{e_{j2}}$ ont même signe où O' est le point d'intersection entre l'axe de rotation O est le plan perpendiculaire à cet axe contenant le premier vecteur $\mathbf{e_{j1}}$ et le deuxième vecteur $\mathbf{ej_2}$.

[Fig. 1]

**Description**

**DOMAINE TECHNIQUE DE L'INVENTION**

Le domaine technique de l'invention est celui des microsystèmes.

La présente invention concerne un microsystème destiné à mesurer un mouvement de rotation et en particulier un microsystème ayant une sensibilité réduite aux déformations du substrat sur lequel est réalisé le microsystème.

**ARRIERE-PLAN TECHNOLOGIQUE DE L'INVENTION**

Il est connu de mesurer les mouvements de rotation à l'aide de microsystèmes. Pour cela, une partie mobile suspendue et possédant un axe de rotation et relié à une partie fixe par une ou plusieurs poutres (servant de jauges de contrainte) est en général utilisé, la partie fixe étant elle-même connectée de manière rigide à un substrat.

Cependant, une telle structure est relativement sensible aux déformations du substrat. Plus particulièrement, la déformation du substrat va entrainer un mouvement de translation entre la partie fixe et la partie mobile, cette translation ayant pour conséquence de déformer les poutres, ces dernières fournissant alors un signal parasite. En pratique, la sensibilité à de tels signaux parasites dépend de la position des ancrages et est en général aggravée par le phénomène d'amplification de la contrainte qui concentre la déformation au niveau des poutres. Une telle structure est également sensible à la dilatation thermique et notamment la dilatation thermique au niveau des poutres qui peut induire un mouvement de rotation de la partie mobile et donc un signal parasite.

Ainsi, il existe un besoin d'une structure permettant de réduire la sensibilité aux déformations du substrat ou bien encore à la dilatation thermique, notamment au niveau des poutres.

**RESUME DE L'INVENTION**

L'invention offre une solution aux problèmes évoqués précédemment en proposant une structure qui, du fait de sa symétrie, permet de réduire l'influence des déformations du substrat ou bien encore de la dilatation thermique sur le signal mesuré.

Un aspect de l'invention concerne un microsystème comprenant :

- Un substrat ;

- Une partie principale reliée au substrat par l'intermédiaire d'un ancrage ;

- Une partie mobile, la partir mobile étant configurée pour tourner autour d'un axe de rotation O ;

- Une première poutre reliant la partie mobile à la partie principale, la direction principale de ladite première poutre étant selon un premier vecteur $e_{j1}$ ayant pour origine la jonction $M_1$ de la partie mobile avec la première poutre et dans le sens de la partie principale ;

- Une deuxième poutre reliant la partie mobile à la partie principale, la direction principale de ladite deuxième poutre étant selon un deuxième vecteur $e_{j2}$ ayant pour origine la jonction $M_2$ de la partie mobile avec la deuxième poutre et dans le sens de la partie principale.

De plus, le premier vecteur $e_{j1}$ et le deuxième vecteur $e_{j2}$ ont la même direction et sont de sens opposé, la position des jonctions $M_1$ et $M_2$ étant choisie de sorte que le produit vectoriel $OM_1 \wedge e_{j1}$ et le produit vectoriel $OM_2 \wedge e_{j2}$ ont le même signe.

La structure ainsi obtenue est peu sensible aux déformations du substrat, la déformation des poutres induites par une telle déformation étant opposée et les signaux associés à ces déformations au niveau de chaque poutre s'annulant donc l'une l'autre lors de la mesure effectuée par un dispositif de mesure de la rotation à l'aide d'un microsystème selon l'invention. Elle est également peu sensible aux effets de la dilatation thermique au niveau de la microstructure ou bien encore de chaque poutre, qui, étant donné la symétrie du microsystème, produisent des efforts thermoélastiques qui s'opposent. Plus particulièrement, la sensibilité des poutres du microsystème aux déformations du substrat a un impact direct sur la stabilité des capteurs utilisant de tels microsystèmes et sur la sensibilité thermique de leur biais/offset (TCO de l'anglais Temperature Coefficient of Offset). Le substrat est en effet soumis à différents phénomènes de relaxation et de dilatation dus en particulier au packaging (comportement des colles par exemple) et aux conditions de montage (report de contrainte mécanique) dans un système

Outre les caractéristiques qui viennent d'être évoquées dans le paragraphe précédent, le microsystème selon un premier aspect de l'invention peut présenter une ou plusieurs caractéristiques complémentaires parmi les suivantes, considérées individuellement ou selon toutes les combinaisons techniquement possibles.

Dans un mode de réalisation, la première poutre (P1) et la deuxième poutre (P2) sont réalisées dans un matériau piézorésistif.

Dans un mode de réalisation, la première poutre (P1) et la deuxième poutre (P2) sont réalisées dans du silicium dopé p ou dopé n.

Dans un mode de réalisation, la distance $OM_1$ projetée selon le vecteur $e_{j1}$ est inférieure ou égale à cinq fois la distance $OM_1$ projetée selon un axe perpendiculaire à $e_{j1}$ et dans le plan de la partie mobile PM et/ou la distance $OM_2$ projetée selon le vecteur $e_{j2}$ est inférieure ou égale à cinq fois la distance $OM_2$ projetée selon un axe perpendiculaire à $e_{j2}$ et dans le plan de la partie mobile PM.

Dans un mode de réalisation, le matériau de la première poutre et la deuxième poutre ont un même module de Young et les relations suivantes sont vérifiées :

$$\frac{S_1 l_2}{S_2 l_1} = \frac{d_2}{d_1}$$

où $l_1$ est la longueur de la première poutre, $l_2$ est la longueur de la deuxième poutre, $d_1$ est la distance qui sépare la première poutre du point de rotation selon un axe perpendiculaire à $ej_1$, $d_2$ est la distance qui sépare la deuxième poutre du point de rotation selon un axe perpendiculaire à $ej_2$, $S_1$ est la section de la première poutre et $S_2$ est la section de la deuxième poutre.

Dans un mode de réalisation, le matériau de la première poutre et de la deuxième poutre ont une même résistivité et un même module de Young et les relations suivantes sont vérifiées :

$$\frac{l_1}{l_2} = \frac{d_2}{d_1} \text{ et } \frac{S_1}{S_2} = \left(\frac{d_2}{d_1}\right)^2$$

où $l_1$ est la longueur de la première poutre, $l_2$ est la longueur de la deuxième poutre, $d_1$ est la distance qui sépare la première poutre du point de rotation selon un axe perpendiculaire à $ej_1$, $d_2$ est la distance qui sépare la deuxième poutre du point de rotation selon un axe perpendiculaire à $ej_2$, $S_1$ est la section de la première poutre et $S_2$ est la section de la deuxième poutre. De préférence, $l_1 = l_2$.

Dans un mode de réalisation, la partie principale comprend :

- une structure de liaison à laquelle sont reliées la première poutre et la deuxième poutre ;

- un bras primaire relié de manière rigide à la structure de liaison ;

- un bras secondaire (BS) relié au substrat par l'ancrage ;

le bras secondaire (BS) étant relié au bras primaire (BP) par au moins une première liaison (L1) ayant une direction principale perpendiculaire à $e_{j1}$ ou $e_{j2}$ et une deuxième liaison (L2) ayant une direction principale perpendiculaire à $e_{j1}$ ou $ej_2$.

Dans un mode de réalisation, la partie principale est dite première partie principale, le microsystème comprenant :

- une deuxième partie principale reliée au substrat par l'intermédiaire d'un ancrage ;

- Une troisième poutre reliant la partie mobile à la deuxième partie principale, la direction principale de ladite troisième poutre étant selon un troisième vecteur $ej_3$ ayant pour origine la jonction $M_3$ de la partie mobile avec la troisième poutre et dans le sens de la deuxième partie principale ;

- Une quatrième poutre reliant la partie mobile à la deuxième partie principale, la direction principale de ladite quatrième poutre étant selon un quatrième vecteur $ej_4$ ayant pour origine la jonction $M_4$ de la partie mobile avec la quatrième poutre et dans le sens de la deuxième partie principale.

De plus, le troisième vecteur $ej_3$ et le quatrième vecteur $ej_4$ ont même direction et sont de sens opposé, la

position des jonctions $M_3$ et $M_4$ étant choisie de sorte que le produit vectoriel $\mathbf{OM_3} \wedge \mathbf{ej_3}$ et le produit vectoriel $\mathbf{OM_4} \wedge \mathbf{ej_4}$ ont même signe et sont de signe opposé à $\mathbf{OM_1} \wedge \mathbf{e_{j1}}$ et $\mathbf{OM_2} \wedge \mathbf{ej_2}$.

Ainsi, les quatre poutres sont en mode « push pull » (autrement dit, elles travaillent de manière opposée - lorsque la première poutre et la deuxième poutre sont en compression, la troisième poutre et la quatrième poutre sont en extension et vice versa) et il est ainsi possible de compenser, au moins en partie, les effets de dilatation thermique.

Dans un mode de réalisation, $\mathbf{ej_1} = -\mathbf{ej_3}$ et $\mathbf{ej_2} = -\mathbf{ej_4}$.

Dans un mode de réalisation, l'ancrage de la deuxième partie principale est identique à l'ancrage de la première partie principale.

Dans un mode de réalisation, la troisième poutre est le symétrique de la première poutre par symétrie axiale selon un axe dans le plan de la partie mobile passant par l'axe de rotation O et perpendiculaire à $\mathbf{e_{j1}}$ et la quatrième poutre est le symétrique de la deuxième poutre par symétrie axiale selon un axe dans le plan de la partie mobile passant par l'axe de rotation O et perpendiculaire à $\mathbf{ej_2}$.

Dans un mode de réalisation, l'axe de rotation O est déporté par rapport à la première poutre et à la deuxième poutre.

Dans un mode de réalisation, le microsystème comprend un plateau de détection relié au substrat par un deuxième ancrage, ledit plateau de mesure étant relié à la partie principale, au niveau de la structure de liaison lorsqu'une telle structure existe, au moyen d'une liaison mécanique, la liaison mécanique et le plateau de mesure étant configuré pour permettre une mesure du potentiel électrique au voisinage de la première poutre et de la deuxième poutre.

Un deuxième aspect de l'invention concerne un dispositif de mesure de la rotation à l'aide d'un microsystème selon un premier aspect de l'invention, ledit dispositif comprenant des moyens de mesure configurés pour mesurer la déformation $\varepsilon_1$ de la première poutre et la déformation $\varepsilon_2$ de la deuxième poutre, et des moyens configurés pour, à partir de ces deux déformations, déterminer l'angle de rotation de la partie mobile.

Outre les caractéristiques qui viennent d'être évoquées dans le paragraphe précédent, le dispositif selon un deuxième aspect de l'invention peut présenter une ou plusieurs caractéristiques complémentaires parmi les suivantes, considérées individuellement ou selon toutes les combinaisons techniquement possibles.

Dans un mode de réalisation, les moyens de mesure sont configurés pour réaliser une mesure quatre point.

Dans un mode de réalisation, le dispositif comprend des moyens de calcul configurés pour déterminer la rotation à partir du signal utile obtenu à l'aide de la relation suivante :

$$S = |\alpha_2|\varepsilon_1 + |\alpha_1|\varepsilon_2$$

où $S$ est le signal utile, $\alpha_1$ est un coefficient de proportionnalité entre un déplacement relatif de la partie mobile selon le vecteur $\mathbf{ej_1}$ par rapport à la partie principale et la déformation de la première poutre, $\alpha_2$ est un coefficient de proportionnalité entre un déplacement relatif de la partie mobile selon le vecteur $\mathbf{e_{j2}}$ par rapport à la partie principale et la déformation de la deuxième poutre. La déformation $\varepsilon_1$ est la déformation de la première poutre selon le vecteur $\mathbf{e_{j1}}$ et $\varepsilon_2$ est la déformation de la deuxième poutre selon le vecteur $\mathbf{ej_2}$.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

La [Fig. 1] montre un microsystème selon un premier mode de réalisation.

La [Fig. 2] montre un microsystème selon un deuxième mode de réalisation.

La [Fig. 3] montre un microsystème selon un troisième mode de réalisation.

La [Fig. 4] montre un microsystème selon un quatrième mode de réalisation.

La [Fig. 5] montre un microsystème selon un cinquième mode de réalisation.

La [Fig. 6] montre un microsystème selon un sixième mode de réalisation.

Les [Fig. 7A], [Fig. 7B] et [Fig. 7C] montrent un microsystème selon un septième mode de réalisation.

La [Fig. 8] montre un microsystème selon un huitième mode de réalisation.

## DESCRIPTION DETAILLEE

Sauf précision contraire, un même élément apparaissant sur des figures différentes présente une référence unique. Par ailleurs, dans la description qui suit, bien que l'état de contrainte pour une déformation donnée dépende de la température et dans la mesure où, dans le contexte de l'invention, la température est a priori la même sur les deux (ou quatre, etc.) poutres, les termes contrainte et déformation seront tous deux utilisés pour décrire l'état mécanique du système (l'un étant proportionnel à l'autre).

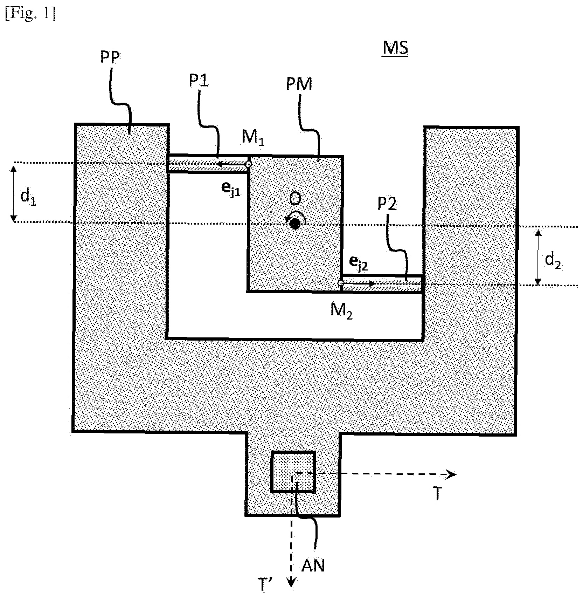

La [Fig. 1] montre une représentation schématique d'un microsystème MS selon l'invention, en général destiné à être utilisé dans un dispositif de mesure de la rotation. Ce microsystème MS comprend un substrat (non représenté), une partie principale PP reliée au substrat par l'intermédiaire d'un ancrage AN et une partie mobile PM configurée pour tourner autour d'un axe de rotation O, ledit axe O étant perpendiculaire à la surface de la partie mobile PM. Cet axe de rotation O peut par exemple être obtenu à l'aide d'un ancrage AN3 reliant la partie mobile au substrat, éventuellement à l'aide d'une structure intermédiaire, et autorisant la rotation de cette partie mobile PM par rapport au substrat selon cet axe O.

Le microsystème MS selon l'invention comprend également au moins deux poutres P1,P2 (ou jauges de contrainte) : une première poutre P1 et une deuxième poutre P2.

La première poutre P1 relie la partie mobile PM à la partie principale PP, la direction principale PP de ladite première poutre P1 étant selon un premier vecteur $\mathbf{e_{j1}}$ ayant pour origine la jonction $M_1$ de la partie mobile PM avec la première poutre P1 et dans le sens de la partie principale PP.

La deuxième poutre P2 relie la partie mobile PM à la partie principale, la direction principale de ladite deuxième poutre étant selon un deuxième vecteur $\mathbf{e_{j2}}$ ayant pour origine la jonction de la partie principale avec la deuxième poutre $M_2$ et dans le sens de la partie fixe. La première poutre P1 et deuxième poutre P2 sont destinées à jouer le rôle de jauge de contrainte.

En outre, le premier vecteur et le deuxième vecteur ont la même direction, sont de sens opposé et le produit vectoriel $\mathbf{OM_1} \wedge \mathbf{e_{j1}}$ et le produit vectoriel $\mathbf{OM_2} \wedge \mathbf{e_{j2}}$ ont le même signe (autrement dit, le même sens).

Ainsi, dans le microsystème MS selon l'invention, la mesurande $s_m$ génère une rotation $\theta$ de la partie mobile PM autour de l'axe de rotation O, cette rotation conduisant la première poutre P1 et la deuxième poutre P2 dans un état de compression de sorte que la déformation $\varepsilon_1$ de la première poutre P1 et la déformation $\varepsilon_2$ de la deuxième poutre P2 sont de même signe.

Dans un mode de réalisation, la distance $OM_1$ projetée selon le vecteur $\mathbf{e_{j1}}$ est inférieure ou égale à cinq fois la distance $OM_1$ projetée selon un axe perpendiculaire à $\mathbf{e_{j1}}$ et dans le plan de la partie mobile PM et/ou la distance $OM_2$ projetée selon le vecteur $\mathbf{e_{j2}}$ est inférieure ou égale à cinq fois la distance $OM_2$ projetée selon un axe perpendiculaire à $\mathbf{e_{j2}}$ et dans le plan de la partie mobile PM.

Dans un exemple de réalisation, la première poutre P1 et la deuxième poutre P2 ont une longueur (mesurée selon l'axe principal de la poutre considérée) comprise entre $1\,\mu m$ et $500\,\mu m$, par exemple égale à $5\,\mu m$.

Dans un exemple de réalisation, la première poutre P1 et la deuxième poutre P2 ont une largeur (mesurée selon un axe perpendiculaire à l'axe principal et dans le plan de la partie mobile PM) et une épaisseur (mesurée selon un axe perpendiculaire au plan de la partie mobile PM) comprise entre 50 nm et $50\,\mu m$, par exemple 250 nm.

Dans un exemple de réalisation, l'épaisseur (mesurée selon un axe perpendiculaire au plan de la partie mobile PM) de la partie principale PP ou de la partie mobiles PM est comprise entre 100 nm et $100\,\mu m$, de préférence entre $10\,\mu m$ et $20\,\mu m$.

*Réjection du signal de déformation*

Afin d'illustrer l'un des avantages d'un microsystème MS selon l'invention, supposons, dans un premier exemple, une déformation du substrat entrainant une translation T (illustrée sur la [Fig. 1]) de l'ancrage AN dans la même direction et le même sens que le vecteur $\mathbf{e_{j2}}$ de sorte à modifier la position de l'ancrage AN par rapport au point de rotation O. Ainsi, la première poutre P1 est mise en compression tandis que la deuxième poutre P2 est mise en extension de sorte que $\varepsilon_1 = -\varepsilon_2$. Aussi, le signal fourni par les poutres P1,P2 s'additionne de manière destructive de sorte que la déformation totale des poutres P1,P2 associée à la déformation du substrat $\varepsilon_c^{de} = \varepsilon_1 + \varepsilon_2$ est nulle. Les méthodes permettant de mesurer la déformation des poutres P1,P2 et donc de convertir cette déformation en signal seront détaillées dans la suite à titre d'illustration, ces méthodes étant par ailleurs bien connues de la personne du métier et faciles à adapter au microsystème MS selon l'invention.

Ainsi, dans le cas d'une translation T de l'ancrage AN dans le même sens que le vecteur $\mathbf{ej_2}$, le microsystème MS selon l'invention fournit une réjection au signal de déplacement des ancrages produit par la déformation du substrat.

Dans un deuxième exemple, une déformation du substrat entraine une translation de l'ancrage AN dans une direction T' (illustrée sur la [Fig. 1]) dans le plan de la partie mobile PM et perpendiculaire au vecteur $\mathbf{e_{j2}}$ de sorte à modifier la position de l'ancrage AN par rapport à l'axe de rotation O. Dans ce deuxième exemple, la première poutre P1 et la deuxième poutre P2 ne subissent aucune déformation à l'ordre 1 de sorte que $\varepsilon_1 = \varepsilon_2 \approx 0$. Ainsi, dans cet exemple également, le microsystème MS selon l'invention fournit une réjection au signal de déplacement de l'ancrage AN (au moins à l'ordre 1).

On notera que toute déformation dans le plan de la partie mobile PM est une combinaison des deux translations T,T' décrites précédemment et que donc, à l'ordre 1, une telle déformation entraine une réjection du signal de déformation.

*Traitement général d'une déformation a*

Dans le cas général, les déformations de la première poutre P1 et de la deuxième poutre P2 sont données par :

[Math. 1]

$$\begin{cases} \varepsilon_1 = \alpha_1 a + \beta_1 s_m \\ \varepsilon_2 = \alpha_2 a + \beta_2 s_m \end{cases}$$

Où $a$ est le déplacement relatif entre la partie principale PP et la partie mobile PM projetée selon la direction principale de la poutre considérée (c'est-à-dire selon $\mathbf{e_{j1}}$ ou $\mathbf{ej_2}$), $\alpha_{1/2}$ est un coefficient de proportionnalité entre le déplacement relatif dans la direction principale de la poutre considérée et la déformation de la poutre considérée et $\beta_{1/2}$ est un coefficient de proportionnalité entre la mesurande $s_m$ et la déformation de la poutre considérée. Comme cela a été montré précédemment, dans un microsystème selon l'invention, $\alpha_1$ et $\alpha_2$ sont de signe opposé tandis que $\beta_1$ et $\beta_2$ sont de même signe. Ainsi, il est possible de rejeter le signal dû au déplacement à l'aide de l'équation suivante :

[Math. 2]

$$S = |\alpha_2|\varepsilon_1 + |\alpha_1|\varepsilon_2 \propto s_m$$

où $S$ est le signal utile. Ainsi, cette combinaison permet d'accéder au signal utile tout en rejetant le signal parasite associé à la déformation a.

*Mesure de la déformation des poutres*

Au moins deux principes sont connus pour mesurer l'état de déformation ou la contrainte dans une poutre.
Le premier principe repose sur la mesure de la fréquence de résonance d'un mode de flexion de la poutre P1, P2 considérée. Une telle mesure nécessite en général des moyens d'actionnement afin de faire vibrer la poutre P1,P2 (par exemple, des moyens d'action capacitif ou thermoélastique, etc.) et des moyens de lecture au niveau de chaque poutre P1 ,P2 (par exemple, des moyens capacitifs ou piézorésistifs, etc.) du mouvement transverse de la poutre considérée. La contrainte ou la déformation est ensuite déterminée à l'aide de la relation suivante :

[Math. 3]

$$\varepsilon \propto \frac{df}{f}$$

Où $f$ est la fréquence de résonnance de la poutre, $df$ est la variation de cette fréquence de résonance et $\varepsilon$ est la déformation ou la contrainte dans la poutre considérée.
Ce principe est par exemple décrit dans T. Miani et al., "Resonant Accelerometers Based on Nanomechanical Piezoresistive Transduction" in 2021 IEEE 34th International Conférence on Micro Electro Mechanical Systems (MEMS), Jan. 2021, pp. 192-195. doi: 10.1109/MEMS51782.2021.9375287.
Le deuxième principe repose sur la mesure de la résistance de la poutre P1 considérée qui dépend de l'état de contrainte par effet piézorésistif (Silicium, Germanium, etc.). Habituellement, une telle mesure de résistance nécessite, pour chaque résistance, la présence de circuits électriques isolés des autres circuits de mesure. La contrainte ou la déformation est ensuite mesurée à l'aide de la relation suivante :

[Math. 4]

$$\varepsilon \propto \frac{dR}{R}$$

Où $R$ est la résistance de la poutre considérée et $dR$ est la variation de cette résistance.

Ainsi, les mesures séparées de la fréquence ou de la résistance permettent d'accéder au signal $S$ introduit précédemment et donc à la mesurande $s_m$. Dans la suite, la mesure de la résistance sera utilisée afin de déterminer le signal utile.

Ce principe est par exemple décrit dans P. Robert et al., "M&NEMS: A new approach for ultra-low cost 3D inertial sensor" in 2009 IEEE Sensors, Oct. 2009, pp. 963-966. doi: 10.1109/ICSENS.2009.5398195 ou bien encore dans le document EP2491406 B1.

Lorsque une mesure de la résistance est utilisée, alors le microsystème MS selon l'invention comprend également des pistes électriques configurées pour pouvoir appliquer une tension ou un courant aux poutres P1,P2 du microsystème et mesurer le courant traversant lesdites poutres ou la tension aux deux extrémités desdites poutres P1,P2.

*Mesure de résistance unique*

Dans un mode de réalisation préférentiel, le microsystème selon l'invention est configuré de sorte qu'une seule mesure de courant permette d'accéder à la déformation des poutres, et donc à la mesurande $s_m$.

Pour mémoire, la conductance $G$ des deux poutres P1 ,P2 correspondant à la mise en parallèle d'une première résistance $R_1$ associée à la première poutre P1 et d'une deuxième résistance $R_2$ associée à la deuxième poutre P2, est donnée par :

[Math. 5]

$$G = \frac{1}{R_1} + \frac{1}{R_2}$$

De plus, la résistance d'une poutre P1 ,P2 peut être mise en relation avec la déformation ou la contrainte dans cette dernière par la relation suivante :

[Math. 6]

$$\frac{dR_1}{R_1} = \pi_\varepsilon \varepsilon_1 \text{ et } \frac{dR_2}{R_2} = \pi_\varepsilon \varepsilon_2$$

Où $\pi_\varepsilon$ est un coefficient de conversion entre la contrainte ou la déformation d'une poutre P1,P2 et la résistance de ladite poutre P1,P2. A partir de ces deux relations et en différentiant l'équation 5, il est possible de dégager la relation suivante :

[Math. 8]

$$dG = -\pi_\varepsilon \left( \frac{\varepsilon_1}{R_1} + \frac{\varepsilon_2}{R_2} \right)$$

Où $dG$ est la variation de conductance.

Afin de permettre une bonne mesure, dans ce mode de réalisation, le microsystème MS est configuré pour qu'un déplacement $a$ de l'ancrage ne génère aucun mouvement de rotation de la partie mobile. Autrement dit, le couple induit par ce déplacement doit être nul au niveau de la partie mobile PM. Cette condition peut être formulé comme :

[Math. 9]

$$d_1 k_1 = d_2 k_2$$

avec $d_1$ la distance au pivot de la première poutre P1, $d_2$ la distance au pivot de la deuxième poutre P2 (voir [Fig. 1]), $k_1$ est la raideur longitudinale de la première poutre P1 et $k_2$ est la raideur longitudinale de la deuxième poutre P2.

Sachant que la raideur longitudinale d'une poutre est donnée par $k = ES_p/l$ où $E$ est le module de Young du matériau dans lequel est réalisé la poutre, $S_p$ est la section de la poutre et $l$ est la longueur de la poutre, la relation précédente peut être reformulée de la manière suivante :

[Math. 10]

$$\frac{S_1 l_2}{S_2 l_1} = \frac{d_2}{d_1}$$

Où $S_1$ est la section de la première poutre P1, $S_2$ est la section de la deuxième poutre P2, $l_1$ est la longueur de la première poutre P1 et $l_2$ est la longueur de la deuxième poutre P2 (il est supposé que les deux poutres P1 ,P2 sont faites dans un même matériau).

Dans un mode de réalisation, la première poutre P1 et la deuxième poutre P2 ont la même résistivité $\rho$. Ainsi, l'équation 8 devient alors :

[Math. 11]

$$dG = -\frac{\pi_\varepsilon}{\rho}\left(S_1 \frac{\varepsilon_1}{l_1} + S_2 \frac{\varepsilon_2}{l_2}\right)$$

De plus, compte tenu des relations décrites précédemment, $\varepsilon_1 = -a/l_1$ et $\varepsilon_2 = a/l_2$. Autrement dit, en valeur absolu, la déformation ou la contrainte est proportionnelle au déplacement a et inversement proportionnelle à la longueur de la poutre considérée P1,P2. Ainsi, pour annuler la sensibilité de $dG$ au déplacement a dans l'équation 11, la relation suivante est vérifiée :

$$\frac{S_1}{(l_1)^2} = \frac{S_2}{(l_2)^2}$$

Autrement formulé, dans ce mode de réalisation, les dimensions de la première poutre P1 et de la deuxième poutre P2 sont choisies de sorte que :

[Math. 12]

$$\frac{l_1}{l_2} = \frac{d_2}{d_1} \text{ et } \frac{S_1}{S_2} = \left(\frac{d_1}{d_2}\right)^2$$

Par exemple, il est possible de fixer $d_1$ et $d_2$ puis de dimensionner la première poutre P1 et la deuxième poutre P2 en fonction du rapport de ces valeurs.

Dans un mode de réalisation avantageux, ces deux dimensions sont choisies telles que $d_1 = d_2$. Ainsi, $l_1 = l_2$

et $S_1 = S_2$. Dans ces conditions, $\varepsilon_1 = \dfrac{-a - d_1\theta}{l_1}$ et $\varepsilon_2 = \dfrac{\mp a - d_2\theta}{l_2}$ où $\theta$ est l'angle de rotation de la partie mobile PM, et les relations suivantes sont vérifiées :

[Math. 13]

$$\frac{dG}{G} = -\frac{dR}{R} = \pi_\varepsilon \frac{d_1\theta}{l_1} = \pi_\varepsilon \frac{d_2\theta}{l_2}$$

Il est ainsi possible, à partir d'une mesure de la conductance G, d'avoir accès à l'angle de rotation $\theta$ de la partie mobile sans avoir à mesurer la résistance de chaque poutre individuellement.

*Découplage des contraintes du substrat*

Afin de limiter encore l'influence des déformations sur le signal mesuré, il peut être souhaitable de découpler une section (ci-après section de liaison SL) de la partie principale PP de l'ancrage AN tout en permettant à cette section de présenter une rigidité suffisante pour qu'une rotation de la partie mobile PM entraine la déformation de la première poutre P1 ou de la deuxième poutre P2.

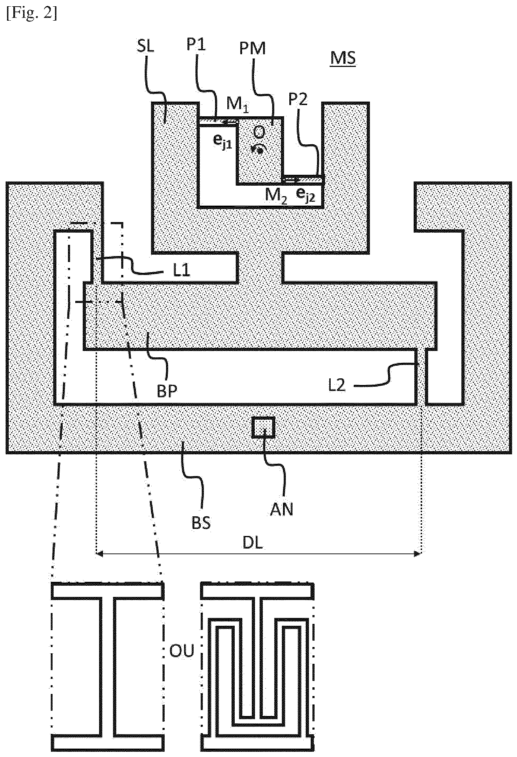

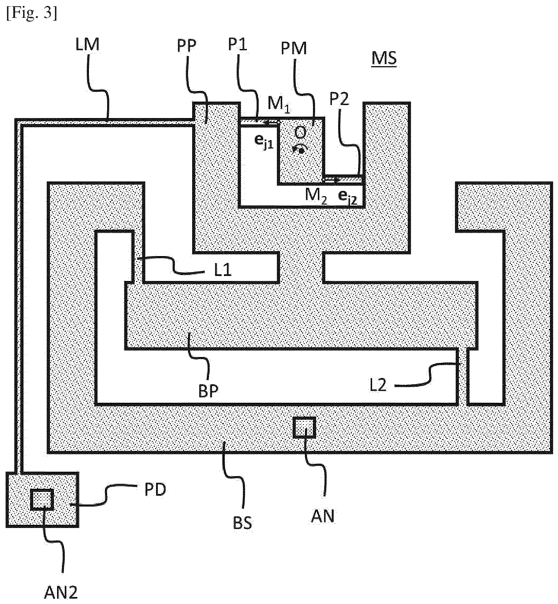

Pour cela, dans un mode de réalisation illustré à la [Fig. 2] ou à la [Fig. 3], la partie principale PP comprend une structure de liaison SL à laquelle sont reliées la première poutre P1 et la deuxième poutre P2. Elle comprend également un bras primaire BP relié de manière rigide à la structure de liaison SL. La partie principale PP comprend également un bras secondaire BS relié au substrat par l'ancrage AN associée à la partie principale PP. Enfin, le bras secondaire est relié au bras primaire par au moins une première liaison L1 et une deuxième liaison L2, la première liaison L1 ayant une direction principale perpendiculaire à $\mathbf{e_{j1}}$ ou $\mathbf{e_{j2}}$ et la deuxième liaison L2 ayant une direction principale perpendiculaire à $\mathbf{e_{j1}}$ ou $\mathbf{e_{j2}}$ de sorte à conférer au bras primaire BP un degré de liberté en translation selon une direction parallèle à la direction principale de la première poutre P1 ou de la deuxième poutre P2.

De plus, la raideur longitudinale de la première liaison L1 et de la deuxième liaison L2 est très grande devant la raideur longitudinale de la première poutre P1 et de la deuxième poutre P2 et la raideur transversale (dans le plan de la partie mobile) de la première liaison L1 et de la deuxième liaison L2 est très faible devant la raideur longitudinale de la première poutre P1 et de la deuxième poutre P2. Ainsi, le bras primaire BP présente une raideur en rotation élevée et la structure de liaison SL (reliée de manière rigide au bras primaire BP) ne sera pas entrainée lors de la rotation de la partie mobile PM.

Dans un mode de réalisation, la distance DL projetée selon un axe parallèle à $\mathbf{e_{j1}}$ ou $\mathbf{e_{j2}}$ séparant la première liaison L1 (ou la deuxième liaison L2) de l'axe de rotation O1 est telle que $L \gg \sqrt{\dfrac{k_{P1}}{k_{L1}}}\, d_1$ , par exemple $L \geq 4\sqrt{\dfrac{k_{P1}}{k_{L1}}}\, d_1$ où $k_{P1}$ est la raideur longitudinale de la première poutre P1, $k_{L1}$ est la raideur longitudinale de la première liaison et $d_1$ la distance séparant la première poutre P1 de l'axe de rotation O1.

Dans un mode de réalisation, le nombre de liaisons entre le bras primaire BP et le bras secondaire BS est supérieure à deux, par exemple égal à quatre, lesdites liaisons étant configurées de sorte que le bras primaire BP présente une raideur en rotation élevée et que donc la structure de liaison SL (reliée de manière rigide au bras primaire BP) ne soit pas entrainée lors de la rotation de la partie mobile PM.

Comme illustré à la [Fig. 2], les liaisons L1, L2 reliant le bras secondaire BS au bras primaire BP peuvent adopter une géométrie relativement simple comme une poutre rectiligne (à gauche sur la [Fig. 2]) ou bien encore une structure plus complexe, comme une poutre formant un ressort (à droite sur la [Fig. 2]).

La structure précédente procure plusieurs avantages. Tout d'abord, si le substrat est précontraint, elle permet de ne pas déséquilibrer la première poutre P1 et la deuxième poutre P2, la déformation étant essentiellement absorbée par les liaisons L1 ,L2 reliant le bras principal BP au bras secondaire BS. Ensuite, elle renforce la protection contre les éventuelles déformations du substrat. De plus, lors de la rotation de la partie mobile PM, la structure ainsi améliorée permet d'obtenir un couple dit « pur » dans le cas où la jauge de rotation est équilibrée (c'est-à-dire, les poutres P1,P2 sont symétriques).

*Mesure à quatre points*

Dans un mode de réalisation illustré à la [Fig. 3], le microsystème MS comprend au moins un plateau de mesure PD relié au substrat par un deuxième ancrage AN2, ledit plateau de mesure PD étant relié à la partie principale PP, de préférence par la structure de liaison SL lorsque cette dernière existe, au moyen d'une liaison mécanique LM, par exemple une poutre, la liaison mécanique LM et le plateau de mesure PD étant configurés pour permettre une mesure du potentiel électrique au voisinage de la première poutre P1 et/ou de la deuxième poutre P2. De plus, la raideur de la liaison mécanique LM dans les deux directions du plan de la partie mobile PM est très faible (par exemple au moins dix fois plus faible, voire au moins cent fois plus faible) devant la raideur longitudinale de la première poutre P1 et de la deuxième poutre P2. De même la raideur mécanique de la liaison LM dans les deux directions du plan de la partie mobile PM est très faible (par exemple au moins dix fois plus faible, voire cent fois plus faible) que la raideur selon les mêmes directions de la partie principale PP à laquelle la liaison LM est connectée par rapport à l'ancrage de ladite partie principale PP.

Dans un mode de réalisation, l'ancrage AN de la partie principale PM et le deuxième ancrage AN2 sont alignés selon un axe parallèle au vecteur $e_{j1}$ ou $e_{j2}$.

En général, lorsque la résistance $R_{SL}$ entre la jonction de la partie principale PP avec la première poutre P1 et la jonction de la partie principale PP avec la deuxième poutre P2 est largement inférieure (par exemple au moins cinq fois inférieure) à la résistance de la première poutre P1 ou de la deuxième poutre P2, alors un plateau de mesure PD est suffisant pour obtenir une bonne mesure de la résistance des poutres P1,P2. De préférence, dans cette configuration, la jonction de la liaison mécanique LM avec la partie principale PP est situé à égale distance de la jonction de la partie principale PP avec la première poutre P1 et de la jonction de la partie principale PP avec la deuxième poutre P2.

Lorsque cette condition n'est pas remplie, de préférence, le microsystème comprend un plateau de mesure relié par un ancrage au substrat et une liaison mécanique pour chaque poutre P1,P2 du microsystème, la jonction de la partie principale PP avec la liaison mécanique associée à chaque poutre P1,P2 étant alors située au plus près de la jonction de la partie principale PP avec ladite poutre P1,P2. Ainsi, la mesure peut être effectuée au plus près de chaque poutre P1,P2.

Ainsi, il est possible de réaliser une mesure quatre points de la résistance électrique de la première poutre P1 et/ou de la deuxième poutre P2. Cette configuration est particulièrement avantageuse lorsqu'elle est combinée avec la présence d'une partie principale PP comprenant un bras primaire BP et un bras secondaire BS, la présence du bras primaire BP, du bras secondaire BS et des liaisons L1,L2 connectant ces derniers étant susceptibles d'ajouter une résistance parasite non négligeable dans un schéma classique de mesure (c'est-à-dire, sans utilisation d'une mesure quatre points).

*Poutres additionnelles*

Dans un mode de réalisation, le microsystème comprend une troisième poutre P3 et une quatrième poutre P4. Dans ce mode de réalisation, la partie principale PP est dite première partie principale PP. De plus, le microsystème MS comprend une deuxième partie principale PP' reliée au substrat par l'intermédiaire d'un ancrage AN'.

De plus, la troisième poutre P3 relie la partie mobile PM à la deuxième partie principale PP', la direction principale de ladite troisième poutre P3 étant selon un troisième vecteur $e_{j2}$ ayant pour origine la jonction $M_2$ de la partie mobile PM avec la troisième poutre P3 et pour sens la deuxième partie principale PP'.

En outre, la quatrième poutre P4 relie la partie mobile PM à la deuxième partie principale PP', la direction principale de ladite quatrième poutre P4 étant selon un quatrième vecteur $e_{j4}$ ayant pour origine la jonction $M_4$ de la partie mobile PM avec la quatrième poutre P4 et pour sens la deuxième partie principale PP'.

De plus, le troisième vecteur $e_{j3}$ et le quatrième vecteur $e_{j4}$ ont la même direction et sont de sens opposé, la position des jonctions M1 et M2 étant choisie de sorte que le produit vectoriel $OM_3 \wedge e_{j3}$ et le produit vectoriel $OM_4 \wedge e_{j4}$ ont même signe et sont de signe opposé à $OM_1 \wedge e_{j1}$ et $OM_2 \wedge e_{j2}$. Autrement dit, la première poutre P1, la deuxième poutre P2, la deuxième poutre P3 et la quatrième poutre P4 sont configurées de sorte que, lors de la rotation de la partie mobile PM, lorsque cette rotation entraine une compression (respectivement une extension) de la première poutre P1 et de la deuxième poutre P2 alors elle entraine une extension (respectivement une compression) de la troisième poutre P3 et de la quatrième poutre P4. Dans un mode de réalisation, $e_{j1} = -e_{j3}$ et $e_{j2} = -e_{j4}$.

Dans les figures, les vecteurs $e_{j1}$ et $e_{j3}$ et les vecteurs $e_{j2}$ et $e_{j4}$ ont même direction. Mais il ne s'agit là que d'un mode particulier de réalisation et ces vecteurs peuvent avoir des directions différentes.

Dans un mode de réalisation préférentiel (non illustré), l'ancrage de la deuxième partie principale PP' est identique à l'ancrage AN de la première partie principale PP (autrement dit, la première partie principale PP et la deuxième partie principale PP ont le même ancrage). Cette configuration est particulièrement adaptée lorsque la mesure de résistance des poutres P1-P4 (et donc de l'état de contrainte de ces dernières) se fait par la mesure de la fréquence de résonance, mais peut également être mise en œuvre lorsque la mesure des résistances est une mesure électrique à la condition d'isoler les circuits de mesure associés à chaque poutre P1-P4. De manière alternative, l'ancrage AN' de la deuxième partie principale PP' est différent de l'ancrage de la première partie principale PP. Bien que moins avantageuse en termes de structure, cette configuration est plus facile à mettre en œuvre lorsque la mesure de la résistance des poutres P1-P4 est une mesure électrique.

Dans un mode de réalisation, la troisième poutre P3 est le symétrique de la première poutre P1 par symétrie axiale selon un axe dans le plan de la partie mobile PM passant par l'axe de rotation O et perpendiculaire à $\mathbf{e_{j1}}$ et la quatrième poutre P4 est le symétrique de la deuxième poutre P2 par symétrie axiale selon un axe dans le plan de la partie mobile PM passant par l'axe de rotation O et perpendiculaire à $\mathbf{e_{j2}}$.

_Axe de rotation déporté_

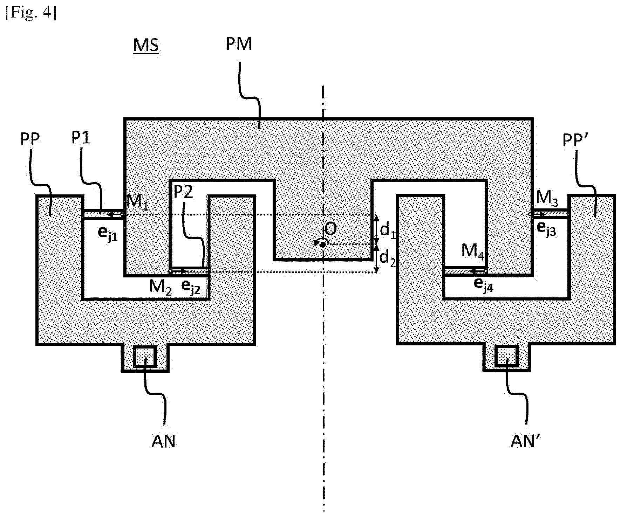

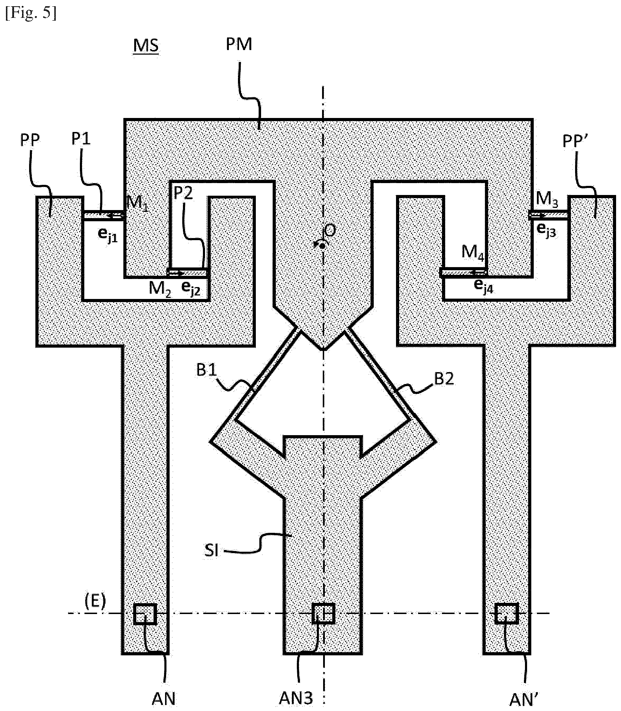

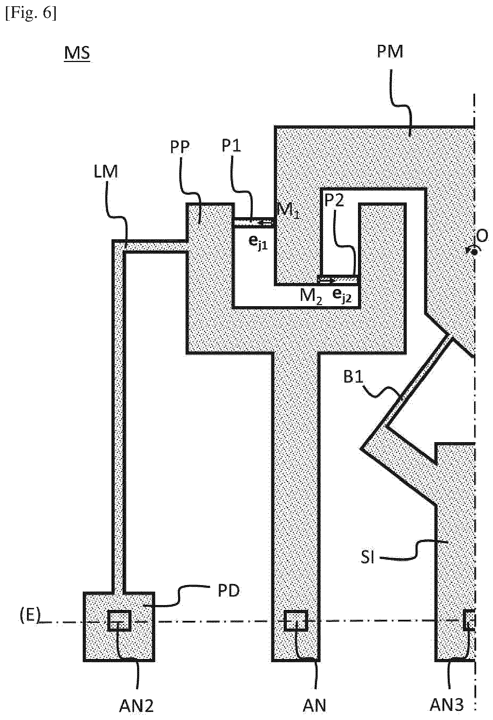

Dans un mode de réalisation illustré à la [Fig. 4], à la [Fig. 5] et à la [Fig 6], l'axe de rotation O est déporté par rapport à la première poutre P1, à la deuxième poutre P2, à la troisième poutre P3 et à la quatrième poutre P4. On entend par déporté par rapport à la première poutre P1 et la deuxième poutre P2 le fait que l'axe de rotation n'est pas situé entre un premier axe perpendiculaire au vecteur $\mathbf{e_{j1}}$ et passant par le point M1 et un deuxième axe perpendiculaire au vecteur $\mathbf{e_{j2}}$ et passant par le point M2, le premier axe et le deuxième axe étant dans le plan de la partie mobile PM (une définition similaire peut être dérivée pour la troisième poutre P3 et la quatrième poutre P4). Il peut être démontré que, en cas de rotation de la partie mobile PM, la déformation longitudinale au niveau de la première poutre P1 et de la deuxième poutre P2 est identique quelle que soit la distance DC projeté selon un axe parallèle à $\mathbf{e_{j1}}$ ou $\mathbf{e_{j2}}$ séparant la première poutre P1 et la deuxième poutre P2 de l'axe de rotation O. Une même démonstration peut être faite pour les déformation longitudinale au niveau de la troisième poutre P3 et de la quatrième poutre P4. De plus, lors de la rotation de la partie mobile, la déformation au niveau de la première poutre P1 et de la deuxième poutre P2 est opposée à la déformation au niveau de la troisième poutre P3 et de la quatrième poutre P4. On notera que, comme illustré aux [Fig. 4] et [Fig. 5], lorsque l'axe de rotation est déporté et que l'empilement technologique ne comprend qu'une seule couche MEMS, il est possible d'utiliser une partie mobile PM commune pour plusieurs (ici deux - le deuxième étant à droite sur les figures) parties principales PP,PP', au moins un couple de poutre P1,P2,P3,P4 étant alors associée à chaque partie principale PP, PP' et disposé selon les enseignements de la présentent invention.

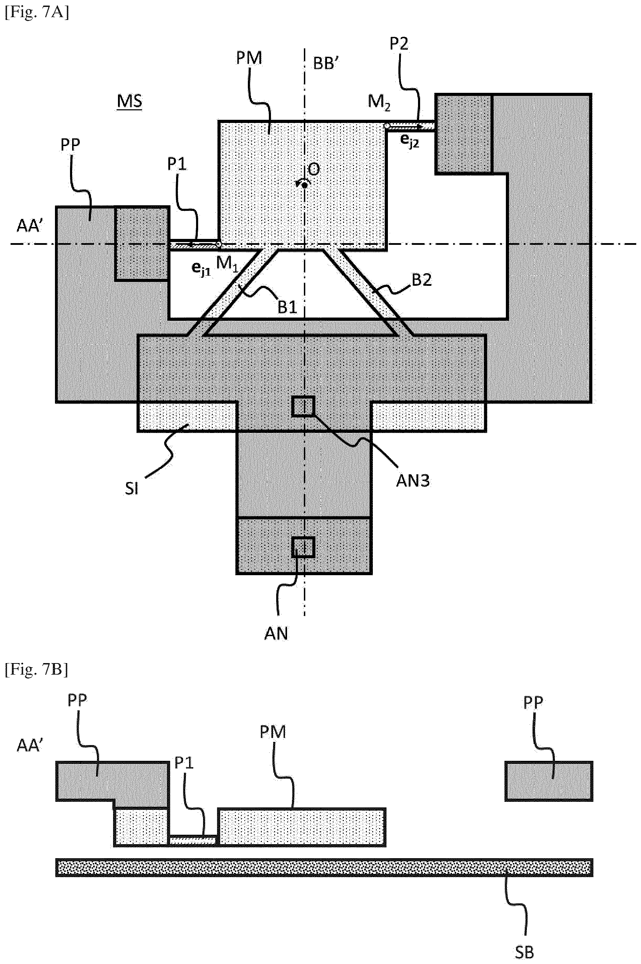

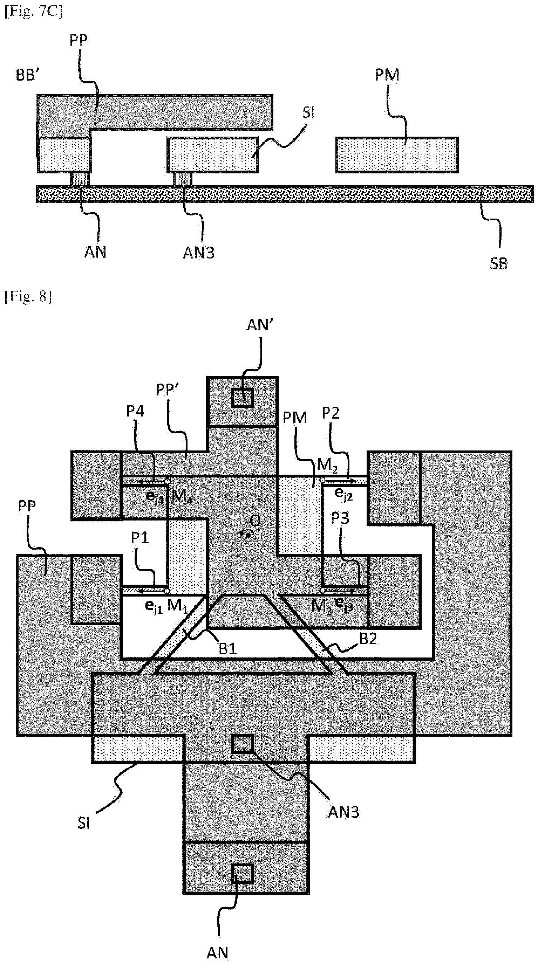

Dans un mode de réalisation illustré à la [Fig. 5] et à la [Fig. 6] (mais aussi aux [Fig. 7A] et [Fig. 8] décrites plus loin), l'axe de rotation O peut être obtenue à l'aide d'une structure intermédiaire SI reliée au substrat à l'aide d'un troisième ancrage AN3 et à la partie mobile PM par l'intermédiaire d'un premier bras B1 et d'un deuxième bras B2. En outre, le premier bras B1 et le deuxième bras B2 sont reliés à la partie mobile PM de sorte à autoriser une rotation de cette dernière selon l'axe O. Dans un mode de réalisation avantageux, la raideur longitudinale du premier bras B1 et du deuxième bras B2 est au moins cinq fois supérieure à la raideur longitudinale de la première poutre P1 ou de la deuxième poutre P2 (c'est-à-dire au moins cinq fois supérieure à plus grande des raideurs longitudinales des poutres P1,P2). De plus, dans ce mode de réalisation, le premier bras B1 et le deuxième bras B2 ont une raideur en torsion (c'est-à-dire le moment produit par le bras considéré lorsqu'on lui impose une rotation à son extrémité) plus petite que la raideur en rotation par rapport au point O produite par la première poutre P1 ou la deuxième poutre P2 (). Pour, mémoire, pour la première poutre P1 par exemple, la raideur en rotation par rapport au point O est donnée par $k_{P1}d_1^2$ (cette formule étant facilement généralisable pour n'importe quelle poutre ou bras).

Dans un mode de réalisation illustré à la [Fig. 5] et la [Fig. 6], l'ancrage AN de la partie principale PM et le troisième ancrage AN3 sont alignés selon un axe (E) parallèle au vecteur $\mathbf{e_{j1}}$ ou $\mathbf{e_{j2}}$.

Dans l'exemple de la [Fig. 6], le microsystème comprend également un plateau de mesure PD et une liaison mécanique telle que décrite précédemment, et le deuxième ancrage AN2 reliant le plateau de mesure PD au substrat est également aligné selon l'axe (E).

L'alignement des différents ancrages AN,AN2,AN3 selon un même axe (E) permet de réduire encore les effets produits par la déformation du substrat.

_Configuration sur plusieurs niveaux_

Dans les exemples qui précèdent, l'essentiel du microsystème MS est réalisé sur un seul et même niveau, ledit niveau étant ensuite relié au substrat par un ou plusieurs ancrages AN,AN2,AN3. Il est cependant possible de réaliser un microsystème MS selon l'invention sur une pluralité de niveaux.

Pour cela, dans un mode de réalisation illustré aux [Fig. 7A] à [Fig. 7C], le microsystème MS est réalisé sur au moins trois niveaux. Dans l'exemple donné aux [Fig. 7A] à [Fig. 7C], la partie principale PP est réalisée sur un premier niveau, tandis que la partie mobile PM, le premier bras B1, le deuxième bras B2 et la structure intermédiaire SI sont réalisés dans un deuxième niveau différent du premier niveau (voir coupe AA' à la [Fig. 7B] et coupe BB' à la [Fig. 7C]). Les premier et deuxième niveaux sont en outre connectés au substrat SB par des ancrages AN,AN3. Comme le montrent les [Fig. 7A] à [Fig. 7C], l'utilisation d'une pluralité de niveaux permet par exemple d'avoir recours à une structure intermédiaire SI pour obtenir l'axe de rotation O sans pour autant avoir à déporter ledit axe de rotation (comme sur le mode de réalisation de la [Fig. 5] et de la [Fig. 6]).

**Dispositif de mesure d'un mouvement de rotation**

Un deuxième aspect de l'invention concerne un dispositif de mesure de la rotation à l'aide d'un microsystème MS selon un premier aspect de l'invention. Plus particulièrement, le dispositif comprend des moyens de mesure configurés pour mesurer la déformation $\varepsilon_1$ de la première poutre P1 et la déformation $\varepsilon_2$ de la deuxième poutre P2. Dans un mode de réalisation, les moyens de mesure sont configurés pour réaliser une mesure quatre point.

Le dispositif de mesure comprend également des moyens de calcul (par exemple un processeur ou une carte ASIC) associé à une mémoire comprenant les instructions nécessaires à la mise en œuvre du dispositif de mesure et notamment pour, à partir de ces deux déformations, de déterminer l'angle de rotation de la partie mobile.

Dans un mode de réalisation, les moyens de mesure sont configurés pour délivrer un signal proportionnel à la combinaison des états de déformation de chaque poutre. Par exemple la mesure de la résistance globale de deux poutres en parallèle fournit, au premier ordre, un signal proportionnel à la somme des états de déformation des deux poutres.

Dans un mode de réalisation alternatif, les moyens de mesure sont configurés pour mesurer de manière indépendante les états de déformation de chaque des poutres, par exemple avec une lecture de la fréquence de résonance mécanique de chaque poutre.

Comme déjà mentionné, ces moyens de mesure sont connus de l'état de la technique et ne seront pas détaillés ici. Le lecteur pourra cependant ce reporter aux deux documents suivants (déjà cités) et aux références qu'ils citent :

- T. Miani et al., "Resonant Accelerometers Based on Nanomechanical Piezoresistive Transduction" in 2021 IEEE 34th International Conférence on Micro Electro Mechanical Systems (MEMS), Jan. 2021, pp. 192-195. doi: 10.1109/MEMS51782.2021.9375287 ;

- P. Robert et al., "M&NEMS: A new approach for ultra-low cost 3D inertial sensor" in 2009 IEEE Sensors, Oct. 2009, pp. 963-966. doi: 10.1109/ICSENS.2009.5398195 ou bien encore dans le document EP2491406 B1.

Dans un mode de réalisation, les moyens de calcul sont configurés pour déterminer la rotation de la partie mobile à partir de l'expression suivante (déjà introduite, voir [Math. 3]) :

[Math. 14]

$$S = |\alpha_2|\varepsilon_1 + |\alpha_1|\varepsilon_2 \propto s_m$$

Où, pour rappel, $S$ est le signal utile, $\alpha_1$ est un coefficient de proportionnalité entre un déplacement relatif de la partie mobile PM selon le vecteur $\mathbf{e_{j1}}$ par rapport à la partie principale PP et la déformation de la première poutre P1, $\alpha_2$ est un coefficient de proportionnalité entre un déplacement relatif de la partie mobile PM selon le vecteur $\mathbf{e_{j2}}$ par rapport à la partie principale PP et la déformation de la deuxième poutre P1, déformation $\varepsilon_1$ est la déformation de la première poutre P1 selon le vecteur $\mathbf{e_{j1}}$ et $\varepsilon_2$ est la déformation de la deuxième poutre P2 selon le vecteur $\mathbf{e_{j2}}$, les déformations étant déterminées à l'aide des moyens de mesure du dispositif.

Ainsi, cette combinaison permet d'accéder au signal utile tout en rejetant le signal parasite associé à la déformation.

**Revendications**

1. Microsystème (MS) comprenant :

   - Un substrat (SB) ;
   - Une partie principale (PP) reliée au substrat par l'intermédiaire d'un ancrage (AN) ;
   - Une partie mobile (PM), la partie mobile (PM) étant configurée pour tourner autour d'un axe de rotation O ;
   - Une première poutre (P1) reliant la partie mobile (PM) à la partie principale (PP), la direction principale de ladite première poutre (P1) étant selon un premier vecteur $\mathbf{e_{j1}}$ ayant pour origine la jonction $M_1$ de la partie

mobile (PM) avec la première poutre (P1) et pour direction la partie principale (PP) ;
- Une deuxième poutre (P2) reliant la partie mobile (PM) à la partie principale (PP), la direction principale de ladite deuxième poutre (P2) étant selon un deuxième vecteur $\mathbf{e_{j2}}$ ayant pour origine la jonction $M_2$ de la partie mobile (PM) avec la deuxième poutre (P2) et pour direction la partie principale (PP) ;

le microsystème (MS) étant **caractérisé en ce que** le premier vecteur $\mathbf{e_{j1}}$ et le deuxième vecteur $\mathbf{e_{j2}}$ ont même direction et sont de sens opposé, la position des jonctions $M_1$ et $M_2$ étant choisie de sorte que le produit vectoriel $\mathbf{O'M_1} \wedge \mathbf{e_{j1}}$ et le produit vectoriel $\mathbf{O'M_2} \wedge \mathbf{e_{j2}}$ ont même signe où O' est le point d'intersection entre l'axe de rotation O est le plan perpendiculaire à cet axe contenant le premier vecteur $\mathbf{e_{j1}}$ et le deuxième vecteur $\mathbf{e_{j2}}$.

2. Microsystème (MS) selon la revendication précédente dans lequel la première poutre (P1) et la deuxième poutre (P2) sont réalisées dans un matériau piézorésistif.

3. Microsystème (MS) selon la revendication précédente dans lequel la première poutre (P1) et la deuxième poutre (P2) sont réalisées dans du silicium dopé p ou dopé n.

4. Microsystème (MS) selon l'une des revendications précédentes dans lequel la distance $OM_1$ projetée selon le vecteur $\mathbf{e_{j1}}$ est inférieure ou égale à cinq fois la distance $OM_1$ projetée selon un axe perpendiculaire à $\mathbf{e_{j1}}$ et dans le plan de la partie mobile PM et/ou la distance $OM_2$ projetée selon le vecteur $\mathbf{e_{j2}}$ est inférieure ou égale à cinq fois la distance $OM_2$ projetée selon un axe perpendiculaire à $\mathbf{e_{j2}}$ et dans le plan de la partie mobile PM.

5. Microsystème (MS) selon l'une des revendications précédentes dans lequel le matériau de la première poutre (P1) et de la deuxième poutre (P2) ont un même module de Young et les relations suivante sont vérifiées :

$$\frac{S_1 l_2}{S_2 l_1} = \frac{d_2}{d_1}$$

où $l_1$ est la longueur de la première poutre, $l_2$ est la longueur de la deuxième poutre, $d_1$ est la distance qui sépare la première poutre du point de rotation selon un axe perpendiculaire à $\mathbf{e_{j1}}$, $d_2$ est la distance qui sépare la deuxième poutre du point de rotation selon un axe perpendiculaire à $\mathbf{e_{j2}}$, $S_1$ est la section de la première poutre et $S_2$ est la section de la deuxième poutre.

6. Microsystème (MS) selon l'une des revendications précédentes dans lequel le matériau de la première poutre (P1) et de la deuxième poutre (P2) ont une même résistivité et un même module de Young et les relations suivantes sont vérifiées :

$$\frac{l_1}{l_2} = \frac{d_2}{d_1} \text{ et } \frac{S_1}{S_2} = \left(\frac{d_2}{d_1}\right)^2$$

où $l_1$ est la longueur de la première poutre, $l_2$ est la longueur de la deuxième poutre, $d_1$ est la distance qui sépare la première poutre du point de rotation selon un axe perpendiculaire à $\mathbf{e_{j1}}$, $d_2$ est la distance qui sépare la deuxième poutre du point de rotation selon un axe perpendiculaire à $\mathbf{e_{j2}}$, $S_1$ est la section de la première poutre et $S_2$ est la section de la deuxième poutre.

7. Microsystème (MS) selon la revendication précédente dans lequel

$$l_1 = l_2.$$

8. Microsystème (MS) selon l'une des revendications précédentes dans lequel la partie principale (PP) comprend :

    - une structure de liaison (SL) à laquelle sont reliées la première poutre (P1) et la deuxième poutre (P2) ;
    - un bras primaire (BP) relié de manière rigide à la structure de liaison (SL) ;
    - un bras secondaire (BS) relié au substrat par l'ancrage (AN) ;
    - le bras secondaire (BS) étant relié au bras primaire (BP) par au moins une première liaison (L1) ayant une direction principale perpendiculaire à $e_{j1}$ ou $e_{j2}$ et une deuxième liaison (L2) ayant une direction principale perpendiculaire à $e_{j1}$ ou $e_{j2}$.

9. Microsystème (MS) selon l'une des revendications précédentes, dans lequel la partie principale est dite première partie principale (PP), le microsystème comprenant :

- une deuxième partie principale (PP') reliée au substrat par l'intermédiaire d'un ancrage (AN') ;
- Une troisième poutre (P3) reliant la partie mobile (PM) à la deuxième partie principale (PP'), la direction principale de ladite troisième poutre (P3) étant selon un troisième vecteur $e_{j3}$ ayant pour origine la jonction $M_3$ de la partie mobile (PM) avec la troisième poutre (P3) et pour sens la partie deuxième principale (PP') ;
- Une quatrième poutre (P4) reliant la partie mobile (PM) à la deuxième partie principale (PP'), la direction principale de ladite quatrième poutre (P4) étant selon un quatrième vecteur $e_{j4}$ ayant pour origine la jonction $M_4$ de la partie mobile (PM) avec la quatrième poutre (P4) et pour sens la deuxième partie principale (PP') ;

le troisième vecteur $e_{j3}$ et le quatrième vecteur $e_{j4}$ ayant même direction et étant de sens opposé, la position des jonctions $M_3$ et $M_4$ étant choisie de sorte que le produit vectoriel $OM_3 \wedge e_{j3}$ et le produit vectoriel $OM_4 \wedge e_{j4}$ ont même signe et sont de signe opposé à $OM_1 \wedge e_{j1}$ et $OM_2 \wedge e_{j2}$.

10. Microsystème (MS) selon la revendication précédente dans lequel $e_{j1} = -e_{j3}$ et $e_{j2} = -e_{j4}$.

11. Microsystème (MS) selon l'une des deux revendications précédentes dans lequel l'ancrage de la deuxième partie principale (PP') est identique à l'ancrage de la première partie principale (PP).

12. Microsystème (MS) selon l'une des trois revendications précédentes dans lequel la troisième poutre (P3) est le symétrique de la première poutre (P1) par symétrie axiale selon un axe dans le plan de la partie mobile (PM) passant par l'axe de rotation O et perpendiculaire à $e_{j1}$ et la quatrième poutre (P4) est le symétrique de la deuxième poutre (P2) par symétrie axiale selon un axe dans le plan de la partie mobile (PM) passant par l'axe de rotation O et perpendiculaire à $e_{j2}$.

13. Microsystème (MS) selon l'une des revendications précédentes dans lequel l'axe de rotation O est déporté par rapport à la première poutre (P1) et à la deuxième poutre (P2).

14. Microsystème (MS) selon l'une des revendication précédentes comprenant un plateau de mesure (PD) relié au substrat par un deuxième ancrage (AN2), ledit plateau de mesure (PD) étant relié à la partie principale (PP), au niveau de la structure de liaison (SL) lorsqu'une telle structure (SL) existe, au moyen d'une liaison mécanique, la liaison mécanique (LM) et le plateau de mesure (PD) étant configuré pour permettre une mesure du potentiel électrique au voisinage de la première poutre (P1) et de la deuxième poutre (P2).

15. Dispositif de mesure de la rotation à l'aide d'un microsystème selon l'une des revendications précédente, ledit dispositif comprenant des moyens de mesure configurés pour mesurer la déformation $\varepsilon_1$ de la première poutre (P1) et la déformation $\varepsilon_2$ de la deuxième poutre (P2), et des moyens configurés pour, à partir de ces deux déformations, de déterminer l'angle de rotation de la partie mobile (PM).

16. Dispositif selon la revendication précédente dans lequel le microsystème est un microsystème selon la revendication 14, les moyens de mesure sont configurés pour réaliser une mesure quatre points.

17. Dispositif selon la revendication 15 ou la revendication 16 comprenant des moyens de calcul configurés pour déterminer la rotation à partir du signal utile obtenu à l'aide de la relation suivante :

$$S = |\alpha_2|\varepsilon_1 + |\alpha_1|\varepsilon_2$$

où $S$ est le signal utile, $\alpha_1$ est un coefficient de proportionnalité entre un déplacement relatif de la partie mobile (PM) par rapport à la partie principale (PP) et la déformation de la première poutre (P1), $\alpha_2$ est un coefficient de proportionnalité entre un déplacement relatif de la partie mobile (PM) par rapport à la partie principale PP et la déformation de la deuxième poutre (P1), déformation $\varepsilon_1$ est la déformation de la première poutre (P1) et $\varepsilon_2$ est la déformation de la deuxième poutre (P2).

[Fig. 1]

[Fig. 2]

[Fig. 3]

[Fig. 4]

[Fig. 5]

[Fig. 6]

[Fig. 7A]

[Fig. 7B]

[Fig. 7C]

[Fig. 8]

Europäisches
Patentamt

European
Patent Office

Office européen
des brevets

**RAPPORT DE RECHERCHE EUROPEENNE**

Numéro de la demande

**EP 22 21 4110**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2021/095949 A1 (GATTERE GABRIELE [IT] ET AL) 1 avril 2021 (2021-04-01) | 1-7,13, 15,17 | INV. B81B7/00 |
| A | * figures 2 - 5 * | 8-12,14, 16 | B81B3/00 |

-----

| | |
|---|---|
| | DOMAINES TECHNIQUES RECHERCHES (IPC) |
| | B81B |

Le présent rapport a été établi pour toutes les revendications

| Lieu de la recherche | Date d'achèvement de la recherche | Examinateur |
|---|---|---|
| Berlin | 4 avril 2023 | McGinley, Colm |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.........................................................
& : membre de la même famille, document correspondant

EPO FORM 1503 03.82 (P04C02)

## EP 4 197 964 A1

## ANNEXE AU RAPPORT DE RECHERCHE EUROPEENNE
## RELATIF A LA DEMANDE DE BREVET EUROPEEN NO.

EP 22 21 4110

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-04-2023

| Document brevet cité au rapport de recherche | Date de publication | Membre(s) de la famille de brevet(s) | | Date de publication |
|---|---|---|---|---|
| US 2021095949 A1 | 01-04-2021 | CN | 112573475 A | 30-03-2021 |
| | | CN | 214114911 U | 03-09-2021 |
| | | EP | 3799311 A1 | 31-03-2021 |
| | | US | 2021095949 A1 | 01-04-2021 |

EPO FORM P0460

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2491406 B1

**Littérature non-brevet citée dans la description**

- **T. MIANI et al.** Resonant Accelerometers Based on Nanomechanical Piezoresistive Transduction. *2021 IEEE 34th International Conférence on Micro Electro Mechanical Systems (MEMS,* Janvier 2021, 192-195
- **P. ROBERT et al.** M&NEMS: A new approach for ultra-low cost 3D inertial sensor. *2009 IEEE Sensors,* Octobre 2009, 963-966

- **T. MIANI et al.** Resonant Accelerometers Based on Nanomechanical Piezoresistive Transduction. *2021 IEEE 34th International Conférence on Micro Electro Mechanical Systems (MEMS),* Janvier 2021, 192-195
- **P. ROBERT E.** M&NEMS: A new approach for ultra-low cost 3D inertial sensor. *2009 IEEE Sensors,* Octobre 2009, 963-966